# EUROPÄISCHE PATENTSCHRIFT

(11) **EP 1 500 942 B1**
(45) Veröffentlichungstag und Bekanntmachung des Hinweises auf die Patenterteilung: **20.06.2007**
(21) Anmeldenummer: 04016965.8
(22) Anmeldetag: 19.07.2004
(51) Int. Cl.: G01R 31/14, G01R 31/12

(54) **Gerät zur Spannungsprüfung von Kabeln und Kabelgarnituren durch eine sehr niederfrequente Spannung**
Device for voltage testing of cables and cable fittings by a very low frequency voltage
Dispositif pour le test de la tension des câbles et des garnitures de câbles à l'aide d'une tension à très basse frequence

(30) Priorität: 21.07.2003 DE 10333241
(43) Veröffentlichungstag der Anmeldung: 26.01.2005
(73) Patentinhaber: Neumann Elektrotechnik GmbH, 09111 Chemnitz (DE)
(72) Erfinder: Pflugbeil, Wilfried, 09111 Chemnitz (DE)
(74) Vertreter: Findeisen Hübner Neumann Seerig

(56) Entgegenhaltungen:
- DE-A- 19 513 441
- DE-A- 19 546 877
- US-B1- 6 169 406
- US-B1- 6 580 783
- PATENT ABSTRACTS OF JAPAN Bd. 015, Nr. 428 (E-1128), 30. Oktober 1991 (1991-10-30) -& JP 03 178561 A (SHOWA ELECTRIC WIRE & CABLE CO LTD), 2. August 1991 (1991-08-02)

## Beschreibung

Die Erfindung betrifft ein Prüfgerät zur Spannungsprüfung von Kabeln und Kabelgarnituren mit einer sehr niederfrequenten Wechselspannung.

Es ist eine Schaltungsanordnung zur Prüfung elektrischer Betriebsmittel, insbesondere von Kabeln und Kabelgarnituren bekannt (DE 19513441 A1), bei der Hochspannungstransformatoren mit niederfrequent modulierten Wechselspannungen gespeist werden und die sekundärseitig anliegende Hochspannung gleichgerichtet wird und zwei Gleichspannungen unterschiedlicher Polarität erzeugt werden. Der Prüfling wird mit der Hochspannung über eine Gleichrichterschaltung definiert aufgeladen. Nach erfolgter Aufladung erfolgt eine definierte Entladung des Prüflings durch Umschaltung einer Hochspannungsschalteinrichtung. Die Hochspannungsschalteinrichtung arbeitet im Pulsbetrieb, wodurch der Prüfling kontinuierlich geladen oder entladen wird. Nachteilig hierbei ist, dass bei dieser Schaltungsanordnung ein sehr hoher Bauelementeaufwand notwendig ist. Dieser macht das Gerät schwer und kostenintensiv.

Aus DE 19546877 A1 ist eine Prüfvorrichtung zur Spannungsprüfung mit VLF-Cosinus-Rechteckspannung von Kabeln und Kabelgarnituren für Hoch- und Mittelspannung bekannt, bei der ebenfalls die an einem Transformator sekundärseitig anliegende Hochspannung gleichgerichtet wird und durch Umpolung der Gleichrichterkaskade ein Umschwingen des Prüflings erfolgt. Bei wiederholter Umpolung der Gleichrichterkaskade schwingt der Prüfling in die Ausgangspolarität zurück. In beiden Fällen wird der Prüfling durch einen Schubkondensator über eine wanderwellenschutzdrossel zur Beseitigung von Verlusten nachgeladen. Durch periodisches Umpolen der Gleichrichterkaskade wird der Prüfling mit einer symmetrischen VLF-Cosinus-Rechteckspannung beaufschlagt. Nachteilig bei dieser Prüfvorrichtung ist, dass schwere Bauelemente wie Schubkondensator oder Wanderwellenschutzdrossel notwendig sind.

Auch ist ein Prüfgerät bekannt (US-A 6169406), dass eine nahezu sinusförmige Ausgangsspannung erzeugt, wobei die abfallende Flanke der Sinushalbwelle (Bereich 90° - 180° bzw. 270° - 360°) durch mehrere Entladestrecken (Entladeschalter und Entladewiderstände) erzeugt wird. Zur Erzeugung der amplitudermodulierten Hochspannung werden zwei Niederspannungstransformatoren benötigt, ein Stelltransformator zur festen Voreinstellung des Gesamtübersetzungsverhältnissen und ein Stufentransformator oder Stelltransformator zur zyklischen niederfrequenten Amplitudenmodulation.

Weiterhin ist ein Prüfgerät zur Simulation und Prüfung von AC-Netzfehlern an Telekommunikationsausrüstungen (US-A 6580783) bekannt, welches mit einem Stelltransformator mit Positionierantrieb, 4 weiteren Transformatoren und einer Vielzahl von Relais, Leistungswiderständen und Kondensatoren definierte Bedingungen für Stromversorgungsfehler erzeugt.

Letzlich ist eine Stromversorgung mit extrem niedrigen Frequenzen (JP-A 3178561) zur Isolationsprüfung von Kabeln bekannt, bei der ein Hochspannungstransformator mit einer niederfrequent modulierten wechselspannung gespeist wird.

Aufgabe der Erfindung ist es, ein Prüfgerät zur Spannungsprüfung von Kabeln und Kabelgarnituren mit einer sehr niederfrequenten wechselspannung zu schaffen, das über weniger und dimensionsmäßig kleinere Bauteile als die bisher bekannten Prüfvorrichtungen verfügt.

Erfindungsgemäß wird die Aufgabe dadurch gelöst, dass ein Stelltransformator, der einen Positionierantrieb aufweist, über einen Niederspannungsschalter mit der Primärwicklung eines Hochspannungstransformators verbunden ist. Dabei ist die Sekundärwicklung des Hochspannungstransformators zum einen über einen Shunt mit der Isolation eines Prüflings und über einen ohmschen Messteiler mit der Seele des Prüflings und zum anderen sowohl über einen ersten Hochspannungsgleichrichter und eine Hochspannungsschalteinrichtung als auch über einen zweiten Hochspannungsgleichrichter und die Hochspannungsschalteinrichtung ebenfalls mit der Seele des Prüflings verbunden. Dem Prüfling ist eine Entladevorrichtung parallel geschaltet. Vorteilhaft ist es, wenn der Stelltransformator ein Niederspannungssparstelltransformator und die Hochspannungsschalteinrichtung ein Umschalter ist. Die Hochspannungsschalteinrichtung kann aber auch aus zwei separaten Schaltern bestehen.

Der Vorteil der Erfindung besteht darin, dass das Gerät ohne schwere Bauelemente wie Schubkondensator oder wanderwellenschutzdrossel auskommt, wodurch es besonders leicht und damit tragbar für den Vor-Ort-Einsatz wird.

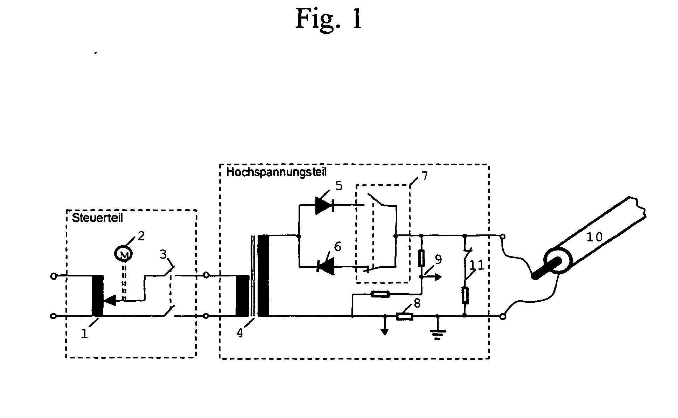

Die Erfindung wird nachfolgend anhand eines in einer Zeichnung dargestellten Ausführungsbeispiels näher erläutert. Dabei zeigt
- Fig. 1:: eine Schaltungsanordnung für ein Prüfgerät zur Spannungsprüfung von Kabeln und Kabelgarnituren mit einer sehr niederfrequenten wechselspannung.

In Figur 1 ist eine Schaltungsanordnung für ein Prüfgerät zur Spannungsprüfung von Kabeln und Kabelgarnituren mit einer sehr niederfrequenten Wechselspannung (VLF-Spannung), bestehend aus einem Steuerteil und einem Hochspannungsteil, dargestellt. Die eingespeiste Netzspannung wird in einer regelbaren Stelleinheit, bestehend aus einem Stelltransformator, beispielsweise einem Niederspannungssparstelltransformator 1 mit einem Positionierantrieb 2, bei gleichbleibender Frequenz in ihrer Amplitude variiert. Die Stelleinheit ist ausgangsseitig direkt oder über einen Niederspannungsschalter 3 mit der Primärwicklung eines Hochspannungstransformators 4 verbunden. Die Sekundärwicklung des Hochspannungstransformators 4 ist zum einen niederohmig, beispielsweise über einen Shunt 8, mit dem auf Betriebserdepotential liegenden Schirmanschluss eines Prüflings 10, beispielsweise einem Kabel, sowie über einen ohmschen Messteiler 9 mit der Seele des Prüflings 10 und zum anderen über einen positiven sowie einen negativen Hochspannungsgleichrichter 5 bzw. 6 und eine Hochspannungsschalteinrichtung 7 ebenfalls mit der Seele des Prüflings 10 verbunden.
Die Hochspannungsschalteinrichtung 7 kann mittels zweier separater Kontakte oder als einfacher Wechsler realisiert sein. Dem Prüfling 10 ist eine schaltbare Entladevorrichtung 11 parallelgeschaltet.
Der Niederspannungsschalter 3 wird geschlossen, die Hochspannungsschalteinrichtung 7 nicht betätigt. Am Niederspannungssparstelltransformator 1 liegt primärseitig Netzspannung an. Durch Bewegen des Positionierantriebes 2 wird die Amplitude der Ausgangsspannung am Niederspannungssparstelltransformator 1 nach einer definierten Funktion erhöht. Diese gesteuerte Spannung ist die Primärspannung für den fest übersetzten Hochspannungstransformator 4. Über den zweiten Hochspannungsgleichrichter 6 und den geschlossenen Öffnerkontakt der Hochspannungsschalteinrichtung 7 wird der Prüfling 10 negativ aufgeladen. Die Form der Ladekurve ist durch die Beeinflussung der Ansteuerung des Positionierantriebes 2 variierbar.

Nach Erreichen der gewünschten Spannung am Prüfling 10 läuft der Positionierantriebes 2 zurück, so dass die Amplitude der Primärspannung des Hochspannungstransformators 4 auf einen definierten Wert reduziert wird. Dadurch erfolgt vorerst keine weitere Ladung des Prüflings 10 bzw. des Kabels. (Bei kapazitiver Last, z.B. einem geschirmten Kabel als Prüfling 10, würde erst dann wieder ein Ladestrom fließen, wenn die Spannung an der Last über den Ableitwiderstand und den Messteiler 9 so weit gesunken ist, dass sie die Spitzenspannung am Ausgang des Hochspannungstransformators 4 zzgl. der Flussspannung des Hochspannungsgleichrichters 6 unterschreitet.)

Nach Ablauf der gewünschten halben Periodendauer der zu erzeugenden VLF-Spannung wird der Niederspannungsschalter 3 geöffnet und die Hochspannungsschalteinrichtung 7 umgeschaltet, d.h., der Öffnerkontakt der Hochspannungsschalteinrichtung 7 wird geöffnet und der Schließerkontakt geschlossen. Über den ersten Hochspannungsgleichrichter 5 fließt ein Strom durch die Hochspannungswicklung des Hochspannungstransformators 4. Lastkapazität und Induktivität der Hochspannungswicklung des Hochspannungstransformators 4 bilden einen Schwingkreis. Die im Prüfling 10 gespeicherte Energie schwingt auf negative Polarität um. Ein erneutes Umschwingen wird durch den ersten Hochspannungsgleichrichter 5 verhindert. Ein Teil der im Prüfling 10 enthaltenen Energie konnte genutzt werden, der restliche Energieanteil wird im Wirkwiderstand der Transformatorwicklung des Hochspannungstransformators 4 in Wärme umgesetzt. Der Prüfling 10 trägt jetzt positive Polarität. Durch das Schließen des Niederspannungsschalters 3 und anschließende definierte Erhöhung der Amplitude der Primärspannung des Hochspannungstransformators 4 wird die Last auf die gewünschte positive Spannung geladen. Durch die Wahl des Zuschaltpunktes des Niederspannungsschalters 3 ist auch die zeitkonstante des Umschwingens beeinflußbar. Aufgrund der Energieerhaltung beim Umschwingen kann bei gleicher Zeit und identischen Ladeströmen gegenüber der ersten Ladung eine betragsmäßig höhere Amplitude am Prüfling 10 erreicht werden. Nach Erreichen der gewünschten Spannung am Prüfling 10 läuft der Positionierantrieb 2 zurück, so dass die Amplitude der Primärspannung des Hochspannungstransformators 4 auf einen definierten Wert reduziert wird.

Nach Ablauf der gewünschten Periodendauer der zu erzeugenden VLF-Spannung wird der Niederspannungsschalter 3 geöffnet und die Hochspannungsschalteinrichtung 7 umgeschaltet, d.h., der Öffnerkontakt der Hochspannungsschalteinrichtung 7 ist geschlossen und der Schließerkontakt geöffnet. Über den zweiten Hochspannungsgleichrichter 6 fließt ein Strom durch die Hochspannungswicklung des Hochspannungstransformators 4. Die im Prüfling 10 gespeicherte Energie schwingt um auf negative Polarität. Dieser Vorgang wiederholt sich ständig.

### Aufstellung der Bezugszeichen

1 Niederspannungssparstelltransformator
2 Positionierantrieb
3 Niederspannungsschalter
4 Hochspannungstransformator
5 erster Hochspannungsgleichrichter
6 zweiter Hochspannungsgleichrichter
7 Hochspannungsschalteinrichtung
8 Shunt
9 ohmscher Messteiler
10 Prüfling
11 Entladevorrichtung

## Patentansprüche

1. Prüfgerät zur Spannungsprüfung von Kabeln und Kabelgarnituren mit einer sehr niederfrequenten Wechselspannung bestehend aus einem Steuerteil und einem Hochspannungsteil, wobei ein Stelltransformator (1), der einen Positionierantrieb (2) aufweist, mit der Primärwicklung eines Hochspannungstransformators (4) verbunden ist und die Sekundärwicklung des Hochspannungstransformators (4) zum einen mit der Isolation eines Prüflings (10) sowie mit der Seele des Prüflings (10) und zum anderen sowohl über einen ersten Hochspannungsgleichrichter (5) und eine Hochspannungsschalteinrichtung (7) als auch über einen zweiten Hochspannungsgleichrichter (6) und die Hochspannungsschalteinrichtung (7) ebenfalls mit der Seele des Prüflings (10) verbunden ist und wobei dem Prüfling (10) eine Entladevorrichtung (11) parallel geschaltet ist, **dadurch gekennzeichnet, dass** der Stelltransformator (1) über einen Niederspannungsschalter (3) mit der Primärwicklung des Hochspannungstransformators (4) verbunden ist und dass die Sekundärwicklung des Hochspannungstransformators (4) zum einen über einen Shunt (8) mit der Isolation eines Prüflings (10) sowie über einen ohmschen Messteiler (9) mit der Seele des Prüflings (10) verbunden ist.

2. Prüfgerät nach Anspruch 1, **dadurch gekennzeichnet, dass** der Stelltransformator ein Niederspannungssparstelltransformator (1) ist.

3. Prüfgerät nach Anspruch 1 oder 2, **dadurch gekennzeichnet, dass** die Hochspannvngsschalteinrichtung (7) ein Umschalter ist.

4. Prüfgerät nach Anspruch 1 oder 2, **dadurch gekennzeichnet, dass** die Hochspannungsschalteinrichtung (7) zwei separate Schalter sind.

## Claims

1. Test set for voltage testing of cables and cable fittings using a very low-frequency AC voltage, comprising a control part and a high-voltage part, with a variable transformer (1) which has a positioning drive (2) being connected to the primary winding of a high-voltage transformer (4) and with the secondary winding of the high-voltage transformer (4) being connected on the one hand to the insulation on a unit under test (10) and to the core of the unit under test (10) and on the other hand both via a first high-voltage rectifier (5) and a high-voltage switching device (7) as well as via a second high-voltage rectifier (6) and the high-voltage switching device (7) likewise to the core of the unit under test (10), and with a discharge apparatus (11) being connected in parallel to the unit under test (10), **characterized in that** the variable transformer (1) is connected via a low-voltage switch (3) to the primary winding of the high-voltage transformer (4), and **in that** the secondary winding of the high-voltage transformer (4) is connected on the one hand via a shunt (8) to the insulation on a unit under test (10), and via a resistive measurement divider (9) to the core of the unit under test (10).

2. Test set according to Claim 1, **characterized in that** the variable transformer is a low-voltage economy transformer (1).

3. Test set according to Claim 1 or 2, **characterized in that** the high-voltage switching device (7) is a changeover switch.

4. Test set according to Claim 1 or 2, **characterized in that** the high-voltage switching device (7) comprises two separate switches.

## Revendications

1. Contrôleur pour réaliser un essai de tension sur des câbles et des accessoires de câble avec une tension alternative à très basse fréquence, composé d'une partie de commande et d'une partie à haute tension, un transformateur de commande (1) qui présente un mécanisme d'entraînement de positionnement (2) étant relié à l'enroulement primaire d'un transformateur à haute tension (4) et l'enroulement secondaire du transformateur à haute tension (4) étant relié d'une part à l'isolant d'un échantillon (10) et à l'âme de l'échantillon (10) et d'autre part également à l'âme de l'échantillon (10) à la fois par le biais d'un premier redresseur à haute tension (5) et d'un dispositif de commutation à haute tension (7) et aussi par le biais d'un deuxième redresseur à haute tension (6) et du dispositif de commutation à haute tension (7) et un dispositif de décharge (11) étant branché en parallèle avec l'échantillon (10), **caractérisé en ce que** le transformateur de commande (1) est relié à l'enroulement primaire du transformateur à haute tension (4) par le biais d'un commutateur à basse tension (3) et que l'enroulement secondaire du transformateur à haute tension (4) est relié d'une part par le biais d'un shunt (8) à l'isolant d'un échantillon (10) et d'autre part par le biais d'un diviseur de mesure ohmique (9) à l'âme de l'échantillon (10).

2. Contrôleur selon la revendication 1, **caractérisé en ce que** le transformateur de commande est un autotransformateur de commande à basse tension (1).

3. Contrôleur selon la revendication 1 ou 2, **caractérisé en ce que** le dispositif de commutation à haute tension (7) est un inverseur.

4. Contrôleur selon la revendication 1 ou 2, **caractérisé en ce que** le dispositif de commutation à haute tension (7) est composé de deux commutateurs séparés.
